# FASCICULE DE BREVET EUROPEEN

(11) **EP 0 432 050 B1**
(45) Date de publication et mention de la délivrance du brevet: **07.04.1993**
(21) Numéro de dépôt: 90403480.8
(22) Date de dépôt: 06.12.1990
(51) Int. Cl.: G11C 16/06

(54) **Circuit de génération de tension de programmation pour mémoire programmable**
Programmierspannungserzeugende Schaltung eines programmierbaren Speichers
Programming voltage generating circuit for programmable memory

(30) Priorité: 07.12.1989 FR 8916198
(43) Date de publication de la demande: 12.06.1991
(73) Titulaire: SGS-THOMSON MICROELECTRONICS S.A., 94250 Gentilly (FR)
(72) Inventeur: Edme, Franck, Cabinet Ballot-Schmidt, F-75116 Paris (FR)
(74) Mandataire: Schmit, Christian Norbert Marie

(56) Documents cités:
- EP-A- 0 217 718
- US-A- 4 447 747
- COMPUTER DESIGN, vol. 22, no. 7, juin 1983, pages 191-196, Winchester, MA, US; K.W. POPE: "No waiting - EEPROM at work"

## Description

L'invention concerne les mémoires électriquement programmables en circuit intégré, connues généralement sous l'appellation "mémoires EEPROM" ou "mémoires EPROM" selon qu'elles sont effaçables électriquement ou non, ou encore "flash EPROM" lorsqu'elles sont effaçables par blocs.

Pour programmer ces mémoires, il est généralement nécessaire de disposer dans le circuit intégré d'une tension dite "tension de programmation", Vpp, qui est nettement supérieure à la tension d'alimentation normale Vcc du circuit. Par exemple, Vcc est couramment égal à 5 volts et Vpp à 15 volts ou plus.

Dans certaines mémoires, la tension de programmation Vpp est fournie par une alimentation extérieure. Mais cela nécessite alors une borne d'alimentation spécifique supplémentaire pour le circuit intégré. Les bornes supplémentaires grèvent fortement le coût des circuits intégrés et on préfère les éviter.

C'est pourquoi on a proposé des mémoires intégrées, dans lesquelles la tension de programmation Vpp est produite à l'intérieur même du circuit intégré, à partir de la tension d'alimentation normale Vcc. On utilise pour cela un circuit classiquement appelé pompe de charge ou élévateur de tension qui reçoit Vcc et établit une tension Vpp supérieure à Vcc.

Les circuits élévateurs utilisent à la base tout simplement des interrupteurs, deux capacités, et une horloge à deux phases pour actionner les interrupteurs. Dans un premier temps on charge la première capacité à 5 volts, puis on la décharge dans la deuxième. Puis un cycle recommence : premier temps, charge de la première capacité à 5 volts, et deuxième temps, décharge dans la deuxième (cette fois la deuxième est déjà partiellement chargée); la tension aux bornes de la deuxième capacité augmente alors. Et ainsi de suite, en quelques coups d'horloge à deux phases, on atteint une tension double de Vcc sur la deuxième capacité. Avec deux étages, on multiplie la tension Vcc par 4 en quelques coups d'horloge.

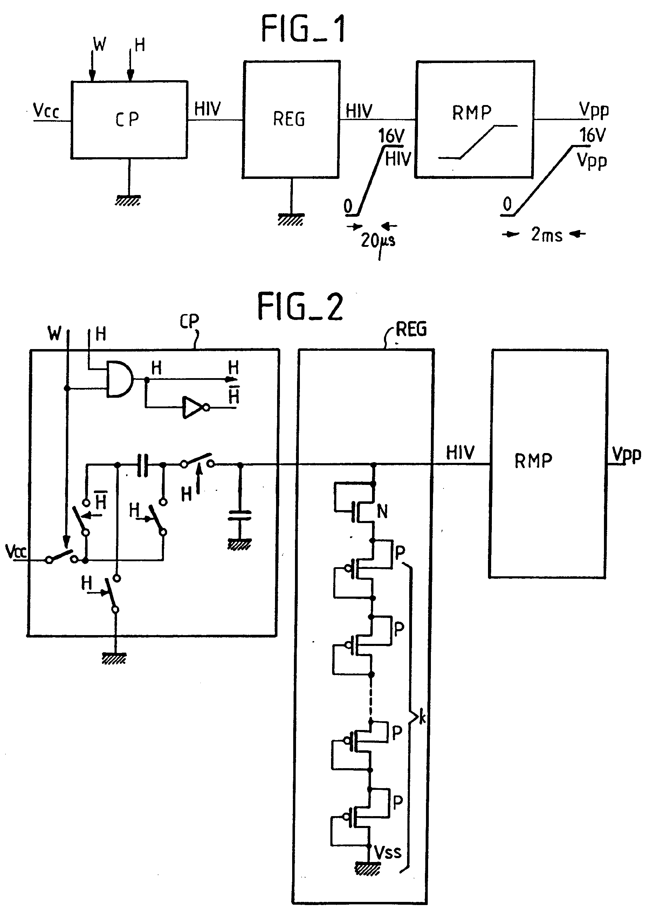

La tension de sortie du circuit élévateur à plusieurs étages est régulée par un régulateur comme le représente la figure 1. Ce régulateur est constitué par une chaîne de transistors qui sont montés en diodes pour établir chacun entre sa source et son drain une tension égale à sa tension de seuil. Selon la technologie mise en oeuvre, la tension de seuil varie et le nombre de transistors en série permet de définir la tension régulée en sortie du régulateur.

Par exemple, pour une tension de seuil de l'ordre de 1 volt des transistors en série montés en diode, il faut 16 transistors pour établir une tension régulée Vpp de l'ordre de 16 volts.

Un des problèmes de ces montages de production de Vpp à l'intérieur du circuit intégré est le suivant : la tension en sortie de l'élévateur de tension et aux bornes du régulateur augmente trop rapidement: avec une horloge de fréquence de l'ordre du mégahertz, il ne faut que quelques microsecondes, par exemple 20 microsecondes pour que la tension atteigne Vpp.

Or on s'est aperçu que lorsque Vpp augmente trop rapidement, la durée de vie des cellules de la mémoire programmées par Vpp diminue considérablement. En effet, Vpp n'est produit qu'au moment de la programmation d'une cellule et le front de montée de Vpp est appliqué directement à la cellule de mémoire en cours de programmation. Le temps de montée trop rapide de Vpp produit des champs électriques induisant une détérioration de l'oxyde de grille des transistors à grille flottante constituant la mémoire.

Pour réduire le temps de montée, on utilise en général en sortie du régulateur une circuiterie analogique complexe et encombrante, délicate à mettre au point et sensible aux paramètres technologiques et à la température. Cette circuiterie produit une tension Vpp montant selon une rampe dont le temps de montée est de l'ordre de 1 à 2 millisecondes, ce qui convient beaucoup mieux et qui permet de faire passer la durée de vie des cellules de 1000 programmations à 100000 programmations.

L'invention a pour but de proposer un circuit beaucoup plus simple à mettre en oeuvre pour limiter le temps de montée de Vpp et ainsi augmenter la durée de vie des cellules programmées. Au lieu de constituer une rampe analogique en sortie du régulateur, on commande numériquement la croissance de la tension établie par le régulateur lui-même, au moyen d'un compteur numérique dont la fréquence de comptage est telle que la tension régulée augmente avec la lenteur désirée.

Pour cela, on propose une mémoire électriquement programmable comportant les caractéristiques de la revendication 1.

Le régulateur comporte de préférence un ensemble de transistors en série, et le moyen de commande numérique relie successivement en série un puis deux puis trois, etc, transistors du régulateur, sous la commande d'un compteur contrôlé par une horloge, de manière à augmenter progressivement, au rythme de l'horloge, la tension aux bornes de l'ensemble en série.

Les transistors sont montés en diode et établissent entre source et drain une tension égale à leur tension de seuil; le moyen de commande numérique comprend de préférence un compteur apte à établir un état logique déterminé successivement sur chacune de ses sorties, et des interrupteurs commandés par les sorties du compteur pour initialement court-circuiter les transistors, puis progressivement les décourtcircuiter les uns après les autres au fur et à mesure du comptage. Il est possible aussi que le compteur commande directement les transistors eux-mêmes pour les placer d'abord dans une configuration où ils sont complètement conducteurs puis dans une configuration où ils établissent une tension de seuil entre source et drain (montage en diode).

Les transistors sont de préférence réalisés chacun dans un caisson séparé diffusé dans un substrat semiconducteur.

Le compteur est un circuit à k sorties établissant à chaque coup d'horloge un niveau logique déterminé sur une nouvelle sortie, en laissant subsister à chaque fois le niveau établi sur la sortie précédente. Le compteur ne revient pas à zéro à la fin de l'activation des k sorties : les niveaux activés, servant à décourt-circuiter les transistors, restent activés autant de temps que la tension de programmation Vpp doit rester présente.

Le régulateur comprend de préférence encore un transistor supplémentaire, de type opposé aux autres, monté avec sa grille et son drain reliés.

D'autres caractéristiques et avantages de l'invention apparaîtront à la lecture de la description détaillée qui suit et qui est faite en référence aux dessins annexés dans lesquels :
- la figure 1 représente un schéma bloc d'un circuit d'élaboration de la tension de programmation Vpp dans l'art antérieur;
- la figure 2 représente un schéma plus détaillé du circuit de la figure 1;
- la figure 3 représente un mode de réalisation de l'invention;
- la figure 4 représente un diagramme temporel de signaux électriques correspondant au circuit de la figure 3.

Le principe d'un circuit d'élaboration de la tension Vpp, dans une mémoire électriquement programmable de l'art antérieur, est rappelé à la figure 1.

Le circuit comprend d'abord une "pompe de charge" CP qui est un circuit élévateur de tension recevant d'une part la tension d'alimentation normale Vcc (en général 5 volts) et d'autre part un signal d'horloge H, et fournissant une tension plus élevée HIV qui est appliquée à un régulateur de tension REG. La pompe de charge CP est activée seulement au moment où une étape d'écriture dans la mémoire programmable doit être effectuée. On peut prévoir par exemple qu'un signal de commande d'écriture W est appliqué à la pompe de charge CP pour déclencher la production d'une tension HIV.

Le régulateur de tension REG a pour fonction de limiter la tension HIV à une valeur déterminée, par exemple 16 volts.

En sortie du régulateur, on obtient, au moment de l'activation du signal d'écriture W, une tension croissant avec un front de montée assez raide (par exemple 20 microsecondes), jusqu'à la valeur HIV définie par le régulateur. En effet, l'horloge est une horloge assez rapide (par exemple 1 mégahertz ou plus) et il ne faut que quelques cycles d'horloge pour que la pompe de charge fournisse un potentiel de 16 volts par exemple.

Comme on a constaté que cette trop grande rapidité de la montée de tension engendre une réduction de la durée de vie des cellules programmées à l'aide de la tension HIV ainsi obtenue, on place à la sortie du régulateur un circuit analogique RMP dont la fonction est d'établir une rampe de croissance plus progressive de la tension de programmation. Ce circuit RMP reçoit la tension HIV et fournit une tension en forme de rampe croissante de 0 à une valeur Vpp (qui peut être égale à la valeur HIV), la pente de croissance étant d'environ 1 à 2 millisecondes pour aller de 0 à Vpp. Cette valeur de 1 à 2 millisecondes résulte d'un compromis entre la nécessité de ne pas détériorer les cellules et la nécessité de limiter la durée des opérations de programmation.

Les circuits RMP utilisés dans la technique antérieure sont complexes (typiquement plusieurs dizaines de transistors), encombrants (ils utilisent des capacités) et ils sont très dépendants des paramètres de réalisation technologiques et de la température.

La figure 2 représente plus en détail certains éléments de la figure 1; notamment elle représente symboliquement et à titre d'illustration, la manière dont peut être réalisée une pompe de charge CP à un seul étage; elle représente aussi en détail le régulateur REG.

Le régulateur REG comprend essentiellement un ensemble de k transistors en série, chaque transistor étant monté en diode, avec sa grille reliée à son drain, de manière que s'établisse entre drain et source de chaque transistor une tension égale à la tension de seuil de ce transistor; il s'établit donc aux bornes de l'ensemble en série des k transistors, dès lors que la tension aux bornes de cet ensemble les met en régime de saturation, une tension égale à la somme des tensions de seuil de tous les transistors, c'est-à-dire égale à k fois la tension de seuil des transistors s'ils ont tous la même tension de seuil Vtp.

Dans l'exemple représenté, l'ensemble en série comprend k transistors à canal P pour une réalisation sur substrat P, chacun des transistors étant réalisé dans un caisson séparé des autres pour avoir une tension de seuil plus stable (suppression de l'effet dit "de substrat" sur la tension de seuil). Le régulateur comprend de préférence en outre un transistor supplémentaire, à canal N, en série avec l'ensemble des transistors P et réalisé directement dans le substrat. Une extrémité de l'ensemble en série des transistors P est reliée au potentiel de masse Vss. L'autre extrémité est reliée à la source du transistor N; celui-ci a son drain relié à la tension de sortie HIV de la pompe de charge.

Le transistor N est lui-même également monté en diode, avec sa grille reliée à son drain. Son rôle est accessoire et il pourrait être supprimé sans rien changer au principe de l'invention.

Le régulateur, ainsi constitué d'un ensemble de transistors en série monté entre la tension HIV et la masse Vss, limite la tension HIV à une valeur Vtn + kVtp. Selon la valeur de tension Vpp désirée et selon la valeur des tensions de seuil des transistors P et N, on choisit le nombre k de transistors nécessaire.

On pourrait éventuellement avoir k transistors P et k′ transistors N. Toutefois on aurait une moins bonne stabilité de tension régulée.

Dans un exemple numérique, la tension de seuil Vtp est de l'ordre de 1 volt, et la tension de seuil Vtn est également de l'ordre de 1 volt (transistor de type naturel, avec effet de substrat). Une quinzaine de transistors P sont nécessaires pour avoir une tension Vpp d'une quinzaine de volts.

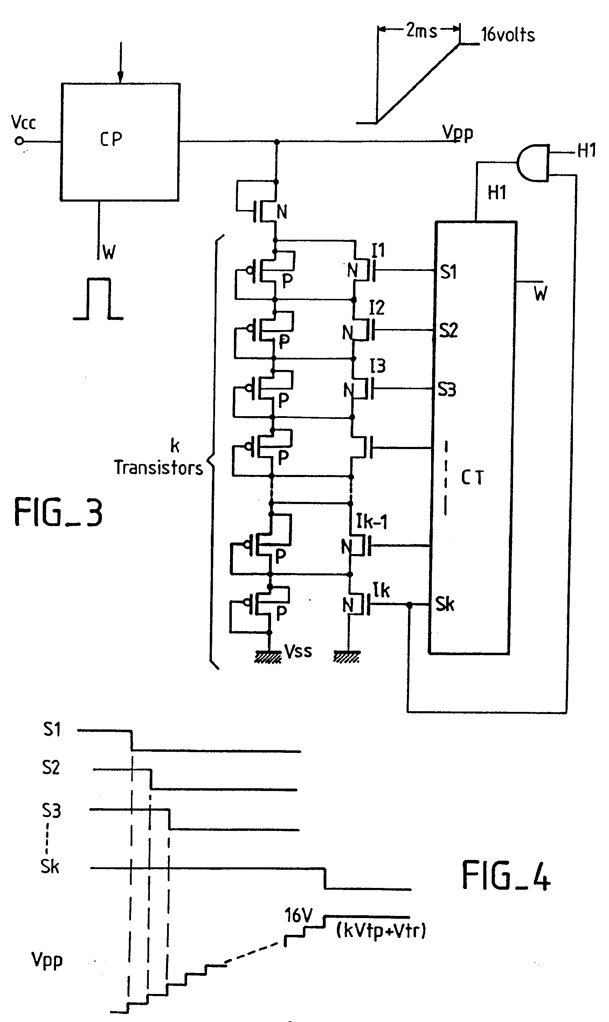

La figure 3 représente un schéma de réalisation d'un circuit d'élaboration de Vpp selon l'invention.

Ce circuit a l'avantage d'utiliser exactement la même pompe de charge et le même régulateur que dans la technique antérieure. Mais il n'utilise plus de circuit de rampe RMP pour convertir une tension HIV à front de montée raide en une tension Vpp à front plus modéré. La tension Vpp désirée, à front de montée modéré, est directement obtenue en sortie de la pompe de charge et du régulateur.

Pour cela, on utilise une commande numérique par un compteur CT pour commander le régulateur et lui faire fournir une tension de régulation variable selon un profil désiré.

L'exemple le plus simple est représenté à la figure 3. Il utilise exactement le même schéma de régulateur que celui qui a été décrit en référence à la figure 2; il utilise aussi un compteur CT à k sorties S1, S2, S3 ... Sk. Le compteur est commandé par une horloge H1 qui sera en général une horloge obtenue par division de fréquence à partir de l'horloge H de la pompe de charge.

Les sorties du compteur commandent des interrupteurs I1, I2, ... Ik, capables de court-circuiter ou décourt-circuiter chacun des transistors de l'ensemble en série de k transistors du régulateur.

Ainsi, la sortie S1 permet de court-circuiter le transistor P le plus proche de Vpp, la sortie S2 le suivant, etc, et la sortie Sk permet de court circuiter le transistor P relié à la masse. Les niveaux logiques présents sur les sorties S1, S2 ... sont entre 0 volt et la haute tension Vpp, le compteur étant par conséquent alimenté par la tension Vpp produite.

Le compteur se déclenche lors de l'ordre de production d'une tension Vpp, ordre fourni par exemple par le signal W qui déclenche aussi la pompe de charge. Au démarrage, le compteur a toutes ses sorties dans un état logique tel qu'elles court circuitent tous les transistors. Dans l'exemple représenté, les interrupteurs commandés par les sorties du compteur sont des transistors à canal N et sont courtcircuités par une tension de niveau haut sur leur grille. On supposera donc qu'au départ les sorties du compteur fournissent toutes un état logique haut.

Le signal W autorise alors le comptage par le compteur. Le compteur n'est pas un compteur binaire (ou s'il l'est il est suivi d'un décodeur); il établit au premier coup d'horloge un état bas sur la sortie S1, puis, au deuxième coup d'horloge, un état bas sur la sortie S2 sans modifier l'état bas de S1, et ainsi de suite, il établit un état bas sur chacune des sorties successives jusqu'à Sk en laissant à chaque fois la sortie précédente dans l'état où il l'a mise au coup d'horloge précédent. En seize coups d'horloge, dans un exemple avec seize transistors P, les sorties sont toutes passées à l'état bas et tous les transistors du régulateur sont décourtcircuités pour aboutir à la constitution de régulateur conforme à la figure 2.

Lorsque la dernière sortie Sk passe à l'état bas elle bloque le comptage (par exemple en bloquant l'horloge H1), de sorte que le régulateur reste dans cette configuration, jusqu'à la fin de l'ordre de production de Vpp, ou même, en pratique, jusqu'à un nouvel ordre d'élaboration de Vpp (nouveau signal d'écriture W).

Il en résulte que même si la pompe de charge produit très rapidement une tension élevée, le régulateur va limiter cette tension à une valeur qui sera d'abord Vtn (tension de seuil du transistor N de l'ensemble en série), puis Vtn+Vtp, puis Vtn+2vtp, etc, jusqu'à Vtn+kVtp c'est-à-dire la tension Vpp finale désirée.

La tension Vpp ainsi limitée par le régulateur à seuil variable va monter en escalier au rythme de l'horloge H1 (qu'il est facile de contrôler précisément et d'élaborer par division de fréquence de l'horloge H de la pompe de charge).

La figure 4 représente cette croissance de la tension limite du régulateur (donc la croissance de Vpp) en relation avec la commutation de l'état logique des sorties successives S1 à Sk du compteur CT.

Dans un exemple numérique inspiré de celui utilisé dans la technique antérieure, on aura par exemple un transistor à canal N en série avec 16 transistors à canal P, les tensions de seuil étant de 1 volt environ. Dans ce cas, le compteur aura 16 sorties, et pour obtenir une tension passant de 0 volts à 16 ou 17 volts environ en un peu moins de 2 millisecondes, il faudra prendre une horloge H1 de 10 kilohertz. Plus généralement, pour obtenir un temps de montée Tm avec un compteur à k sorties et un régulateur ayant k tensions limites possibles, on utilisera une horloge de fréquence k/Tm. La fréquence pourra être entre k/2 et k kilohertz pour un temps de montée de 1 à 2 millisecondes.

L'expérience montre que les échelons de la tension Vpp ne sont pas très gênants; d'une part ils n'existent que pendant la phase transitoire de montée de Vpp; d'autre part les nombreuses résistances et capacités parasites des circuits que Vpp est destinée à alimenter atténuent très fortement ces échelons.

## Revendications

1. Mémoire électriquement programmable, comportant un circuit d'élaboration d'une tension de programmation Vpp supérieure à la tension d'alimentation normale Vcc de la mémoire, ce circuit comportant un circuit élévateur de tension (CP) délivrant en sortie la tension Vpp, et suivi d'un régulateur de tension (REG) servant à limiter la tension Vpp à une valeur limite désirée, caractérisée en ce que le régulateur comprend entre la tension Vpp et la masse, un ensemble de transistors en série, montés en diode et établissant entre source et drain une tension égale à leur tension de seuil (Vtp), et en ce qu'un moyen de commande numérique comprend un compteur (CT) apte à établir un état logique déterminé successivement sur chacune de ses sorties, et un moyen (31 à 3k) commandé par les sorties du compteur pour initialement court-circuiter les transistors, puis progressivement les décourtcircuiter les uns après les autres au fur et à mesure du comptage.

2. Mémoire selon la revendication 1, caractérisée en ce que le compteur est un circuit à k sorties établissant à chaque coup d'horloge un niveau logique déterminé sur une nouvelle sortie, en laissant subsister à chaque fois le niveau établi sur la sortie précédente, et en ce qu'il est prévu un moyen pour arrêter le comptage lorsque la dernière sortie a été mise au niveau déterminé.

3. Mémoire selon la revendication 2, caractérisée en ce que le compteur et la pompe de charge sont activés par un signal (W) de commande de programmation de la mémoire.

4. Mémoire selon l'une des revendications 1 à 3, caractérisée en ce que les transistors sont réalisés chacun dans un caisson séparé diffusé dans un substrat semiconducteur.

5. Mémoire selon la revendication 4, caractérisée en ce que les transistors sont de même type, et en ce que le régulateur comporte au moins un transistor supplémentaire de type opposé.

6. Mémoire selon l'une des revendications 1 à 5, caractérisée en ce que le compteur comporte k sorties et en ce qu'il est incrémenté à une fréquence de l'ordre de k/2 à k kilohertz, pour obtenir un temps de croissance de la tension Vpp de l'ordre de 1 à 2 millisecondes.

## Patentansprüche

1. Elektrisch programmierbarer Speicher mit einer Schaltung zum Erzeugen einer Programmierspannung Vpp, die größer als die normale Versorgungsspannung Vcc des Speichers ist, wobei diese Schaltung eine Spannungserhöhungsschaltung (CP) enthält, die am Ausgang die Spannung Vpp liefert und auf die ein Spannungsregler (REG) folgt, der dazu dient, die Spannung Vpp auf einen gewünschten Grenzwert zu begrenzen, dadurch gekennzeichnet, daß der Regler zwischen der Spannung Vpp und Masse eine Gruppe von in Serie geschalteten Transistoren enthält, die als Dioden geschaltet sind und zwischen Source und Drain eine Spannung aufbauen, die gleich ihrer Schwellenspannung (Vtp) ist, und daß ein digitales Steuermittel vorgesehen ist, das einen Zähler (CT) enthält, der nacheinander an jedem seiner Ausgänge einen Logikzustand erzeugen kann, und ein Mittel (31 bis 3k) enthält, das von den Ausgängen des Zählers gesteuert wird, um die Transistoren anfänglich kurzzuschließen und dann nach Maßgabe der Zählung fortschreitend an einem nach dem anderen den Kurzschluß zu entfernen.

2. Speicher nach Anspruch 1, dadurch gekennzeichnet, daß der Zähler eine Schaltung mit k Ausgängen ist, die mit jedem Takt an einem neuen Ausgang einen gewünschten Logikpegel erzeugt, wobei jedesmal der am vorangehenden Ausgang erzeugte Pegel beibehalten wird, und daß ein Mittel vorgesehen ist, um den Zählvorgang anzuhalten, wenn der letzte Ausgang auf den vorbestimmten Pegel gestellt worden ist.

3. Speicher nach Anspruch 2, dadurch gekennzeichnet, daß der Zähler und die Ladungspumpe durch ein Signal (W) zum Steuern der Programmierung des Speichers aktiviert werden.

4. Speicher nach einem der Ansprüche 1 bis 3, dadurch gekennzeichnet, daß die Transistoren jeweils in einer getrennten diffundierten Wanne in einem Halbleitersubstrat gebildet sind.

5. Speicher nach Anspruch 4, dadurch gekennzeichnet, daß die Transistoren vom gleichen Typ sind und daß der Regler wenigstens einen zusätzlichen Transistor vom entgegengesetzten Typ enthält.

6. Speicher nach einem der Ansprüche 1 bis 5, dadurch gekennzeichnet, daß der Zähler k Ausgänge aufweist und daß er mit einer Frequenz in der Größenordnung von k/2 bis k Kilohertz fortgeschaltet wird, um Anstiegszeiten der Spannung Vpp in der Größenordnung von 1 bis 2 Millisekunden zu erhalten.

## Claims

1. An electrically programmable memory comprising a circuit for establishing a programming voltage Vpp higher than the normal supply voltage Vcc of the memory, this circuit comprising a voltage multiplier circuit (CP) delivering the voltage Vpp at its output and followed by a voltage regulator (REG) used to restrict the voltage Vpp to a desired limit value, characterised in that the regulator has, between the voltage Vpp and the earth, a set of transistors in series mounted as diodes and establishing, between source and drain, a voltage equal to their threshold voltage, and in that a digital control means includes a counter (CT) suitable for setting up a determined logic state successively at each of its outputs, and a means (Il to Ik) controlled by the outputs of the counter to initially short-circuit the transistors and then un-short-circuit them progressively as and when the counting takes place.

2. A memory according to Claim 1, characterised in that the counter is a circuit with k outputs which sets up at each clock pulse a determined logic level at a new output, while leaving in place each time the level set up at the previous output, and in that there is provision for a means to stop the counting when the last output has been set at the determined level.

3. A memory according to Claim 2, characterised in that the counter and the charge pump are activated by a memory programming command signal (W).

4. A memory according to any one of Claims 1 to 3, characterised in that the transistors are each formed in a separate well diffused in a semi-conductor substrate.

5. A memory according to Claim 4, characterised in that the transistors are of the same type, and in that the regulator includes at least one additional transistor of an opposite type.

6. A memory according to one of the Claims 1 to 5, characterised in that the counter includes k outputs, and in that it is incremented at a frequency of the order of k/2 to k kilohertz in order to obtain a rising time for the voltage of the order of 1 to 2 milliseconds.
